# EUROPÄISCHE PATENTSCHRIFT

(11) **EP 1 462 661 B1**
(45) Veröffentlichungstag und Bekanntmachung des Hinweises auf die Patenterteilung: **05.04.2006**
(21) Anmeldenummer: 04005500.6
(22) Anmeldetag: 08.03.2004
(51) Int. Cl.: F15B 15/28, G01D 5/14

(54) **Positionsmessvorrichtung für fluidische Zylinder-Kolben-Anordnungen**
Position determination device for fluid actuated piston-cylinder assemblies
Dispositif de détermination de la position d'ensembles cylindres et pistons à commande fluidique

(30) Priorität: 26.03.2003 DE 10313676
(43) Veröffentlichungstag der Anmeldung: 29.09.2004
(73) Patentinhaber: IMI Norgren-Herion Fluidtronic GmbH & Co. KG, 70736 Fellbach (DE)
(72) Erfinder: Sielemann, Ulrich, 70192 Stuttgart (DE)
(74) Vertreter: Jakelski, Joachim

(56) Entgegenhaltungen:
- EP-A- 0 417 024
- DE-A- 3 442 879
- US-A- 5 907 200
- US-A- 6 137 403
- PATENT ABSTRACTS OF JAPAN Bd. 2000, Nr. 06, 22. September 2000 (2000-09-22) & JP 2000 088506 A (OMRON CORP; TAIYO LTD), 31. März 2000 (2000-03-31)

## Beschreibung

Die Erfindung betrifft eine Positionsmeßvorrichtung für fluidische Zylinder-Kolben-Anordnungen nach dem Oberbegriff des Anspruchs 1.

Ein solcher Stellungsgeber zur Anzeige der Lage eines Kolbens innerhalb eines Zylinders in einer Zylinder-Kolben-Anordnung in einem Bremssystem ist beispielsweise aus der DE 100 53 955 A1 bekannt. Hierbei wird ein hydraulischer Geberzylinder mit einem Hall-Element versehen, wobei in die Zylinderwand ein Hall-Element eines Hallsensors eingefügt ist und in der Kolben-Zylinder-Anordnung ein magnetischer Bezirk derart angeordnet ist, daß durch die Kolbenbewegung in dem Zylinder das Hall-Element anspricht. Eine Kolben-Zylinder-Anordnung, bei der die Position des Kolbens mittels Hallsensoren erfaßt, wird geht des weiteren auch aus der EP 0 536 926 B1 hervor.

Eine Positionsmeßvorrichtung für fluidische Zylinder mit einer langgestreckten Meßspule, die als Wirbelstrom-Langwegsensor ausgebildet ist, geht aus der DE 202 05 822 U1 hervor.

Ferner ist es bekannt, die Stellung des Kolbens durch kapazitive Sensoren zu erfassen. Ein Arbeitszylinder mit einem Sensor zur Bestimmung der Position des Kolbens mittels kapazitiver Sensoren ist aus der DE 44 10 363 A1 bekannt.

Ein Stellgeber zur Anzeige der Lage eines Kolbens ist beispielsweise aus der EP0417024 A1 bekannt.

In vielen Fällen müssen nun bei fluidischen Zylinder-Kolben-Anordnungen die End- bzw. Anschlagspositionen beispielsweise bei der Inbetriebnahme oder während des Betriebes geändert und eingestellt werden. Hierzu sind beispielsweise bei einigen bekannten Kolben-Zylinder-Anordnungen in einer Nut im Zylinderprofil befestigte Schaltelemente vorgesehen. Die Einstellung einer Position erfolgt durch Verschieben der Schaltelemente in der Nut des Zylinderprofils.

Nachteilig bei einer derartigen Anordnung ist außer der notwendigen manuellen Einstellung auch die aufgrund des Aufbaus resultierende zerklüftete Oberfläche des Zylinders, die einen Einsatz in Bereichen mit erhöhten Anforderungen an die Hygiene, beispielsweise in der Lebensmittel- und Pharmaindustrie, kaum zuläßt.

Der Erfindung liegt daher die Aufgabe zugrunde, eine Positionsmeßvorrichtung für fluidische Zylinder-Kolben-Anordnungen zu vermitteln, welche nicht nur eine technisch einfach zu realisierende Möglichkeit der Einstellung der zu detektierenden End- bzw. Anschlagspositionen ermöglicht, sondern die darüber hinaus auch auf einfache Weise in ein Zylinderprofil integriert werden kann.

Diese Aufgabe wird erfindungsgemäß durch eine Positionsmeßvorrichtung für fluidische Zylinder-Kolben-Anordnungen mit den Merkmalen des Anspruchs 1 gelöst.

Durch die Anordnung eines Hallsensorarrays umfassend wenigstens zwei in Bewegungsrichtung des Kolbens voneinander beabstandete Hallsensoren und eine Spule, durch deren Magnetfeld die Schaltpunkte der Hallsensoren abhängig von dem Strom, mit dem die Spule beaufschlagbar ist, einstellbar sind, wird auf sehr vorteilhafte Weise nicht nur eine elektronische Auswahl einzelner Hallsensoren ermöglicht, sondern es wird insbesondere auch eine Interpolation zwischen den einzelnen Hallsensoren ermöglicht. Auf diese Weise kann die Anzahl der Hallsensoren bei gleichzeitig sehr hoher Präzision der Erfassung der Position gering gehalten werden.

Durch die in den Unteransprüchen aufgeführten Maßnahmen sind vorteilhafte Weiterbildungen und Verbesserungen der im Anspruch 1 angegebenen Positionsmeßvorrichtung möglich.

In vorteilhafter Weise umfaßt das Hallsensorarray eine Mehrzahl von gleich beabstandeten, vorzugsweise auf einer Trägerplatte angeordneten Hallsensoren. Durch diese Anordnung wird die Genauigkeit der Positionserfassung gesteigert. Darüber hinaus kann die Einstellung auf die erforderliche Schaltposition durch eine im folgenden noch näher beschriebene elektronische Auswahl der entsprechenden Hallsensoren erfolgen.

Die Hallsensoren sind vorzugsweise linear hintereinanderliegend angeordnet und von einer im wesentlichen rechteckförmigen rahmenförmigen Spule (Rahmenspule) umgeben. Durch die von einem elektrischen Strom durchflossene Rahmenspule wird ein Magnetfeld erzeugt, das sich dem Magnetfeld des magnetischen Bereichs des Zylinders überlagert und besonders gut mit den Hallsensoren zusammenwirkt. Auf diese Weise ergibt sich die vorteilhafte Möglichkeit, über die Größe des Spulenstroms die magnetische Flußdichte am Einbauort der Hallsensoren zu variieren und damit gewissermaßen eine Interpolation des Ansprechverhaltens zwischen den einzelnen Hallsensoren zu ermöglichen.

Bei einer vorteilhaften Ausführungsform ist dabei vorgesehen, daß die Rahmenspule auf einer Seite der Trägerplatte angeordnet ist, wohingegen die Hallsensoren auf der anderen Seite der Trägerplatte angeordnet sind. Durch diese Anordnung ergibt sich ein sehr kompakter Aufbau des Hallsensorarrays.

Die Auswahl der Hallsensoren kann auf die unterschiedlichste Art und Weise erfolgen. Bei einer vorteilhaften Ausführungsform ist vorgesehen, die Hallsensoren mittels eines Multiplexers auszuwählen und ihre Schaltzustände einem Microcontroller zuzuführen.

Die Rahmenspule wird vorteilhafterweise mittels eines Stromreglers auf jeweils einen konstanten Wert eingestellten Strom beaufschlagt, der insbesondere unabhängig von der Versorgungsspannung und von der Spulentemperatur ist. Die Spulenströme werden vorzugsweise von dem Microcontroller vorgegeben.

Zur Festlegung einer zu detektierenden Position des Kolbens werden bei einer vorteilhaften Ausführungsform eine Positionsnummer eines dem magnetischen Bereich des Kolbens am nächsten benachbarten Hallsensors und die Größe des entsprechenden Spulenstroms in einem Speicher des Microcontrollers abgelegt.

Bei einem späteren Betrieb der Zylinder-Kolben-Anordnung ermittelt der Microcontroller dann die Positionsnummer eines aktiven Hallsensors und den zugehörigen Spulenstrom, vergleicht diese Werte mit in dem Speicher des Microcontrollers gespeicherten Werten und gibt im Falle der Übereinstimmung ein Ausgangssignal aus.

Ein sehr großer Vorteil dieser Positionsmeßvorrichtung ist ihre Einstellbarkeit auf elektronischem Wege. Es sind insbesondere keine mechanischen Eingriffe erforderlich. Ferner ist sehr vorteilhaft, daß mit dieser Positionsmeßvorrichtung sehr genaue Positionsbestimmungen des Kolbens der Kolben-Zylinder-Anordnung bei einfach zu realisierendem Aufbau möglich sind.

Weitere Vorteile und Merkmale der Erfindung sind Gegenstand der nachfolgenden Beschreibung sowie der zeichnerischen Darstellung von Ausführungsbeispielen.

In der Zeichnung zeigen:
- Fig. 1: schematisch eine Kolben-Zylinder-Anordnung mit einer Positionsmeßvorrichtung gemäß vorliegender Erfindung;
- Fig. 2: schematisch die Ausgangssignale der Hallsensoren des Hallsensorarrays über dem Zylinderhub;
- Fig. 3: schematisch den Aufbau eines Hallsensorarrays gemäß vorliegender Erfindung;
- Fig. 4a: schematisch die Beaufschlagung der Rahmenspule gemäß vorliegender Erfindung mit einem Strom;
- Fig. 4b: die Abhängigkeit des Stroms von der Kolbenposition und
- Fig. 5: schematisch eine Schaltungsanordnung zur Festlegung einer zu detektierenden Position und zur Feststellung dieser Position im Betrieb der Kolben-Zylinder-Anordnung.

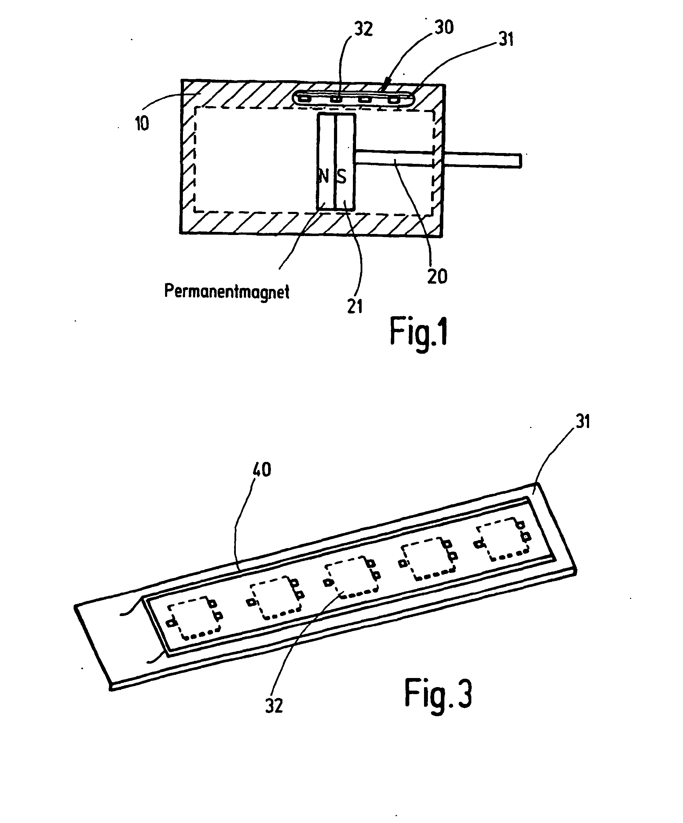

Eine Kolben-Zylinder-Anordnung umfassend einen Zylinder 10 und einen Kolben 20 ist in Fig. 1 schematisch dargestellt. In einer Zylinderwand ist ein mit 30 bezeichnetes Hallsensorarray angeordnet, welches eine Mehrzahl von auf einer Leiterplatte 31 angeordneten Hallsensoren 32 umfaßt. Bei der in Fig. 1 dargestellten Kolben-Zylinder-Anordnung ist das Hallsensorarray 30 in einer Zylinderwand angeordnet. Es versteht sich, daß die Erfindung hierauf nicht beschränkt ist, sondern es vielmehr auch möglich ist, das Hallsensorarray beispielsweise auch außerhalb der Zylinderwand oder beabstandet von der Zylinderwand anzuordnen.

Die Hallsensoren 32 sind linear hintereinander und im wesentlichen voneinander gleich beabstandet auf der Leiterplatte 31 längs der Hubbewegungsrichtung des Zylinders 20 angeordnet. Im Zylinderkopf 20 ist ein magnetischer Bereich, beispielsweise gebildet durch einen Permanentmagneten 21 vorgesehen. Die Hallsensoren 32 können insbesondere auch als Hallschalter ausgebildet sein, die unmittelbar einen Schaltvorgang auslösen, wenn der Permanentmagnet 21 jeweils einem Hallschalter 32 gegenüberliegt.

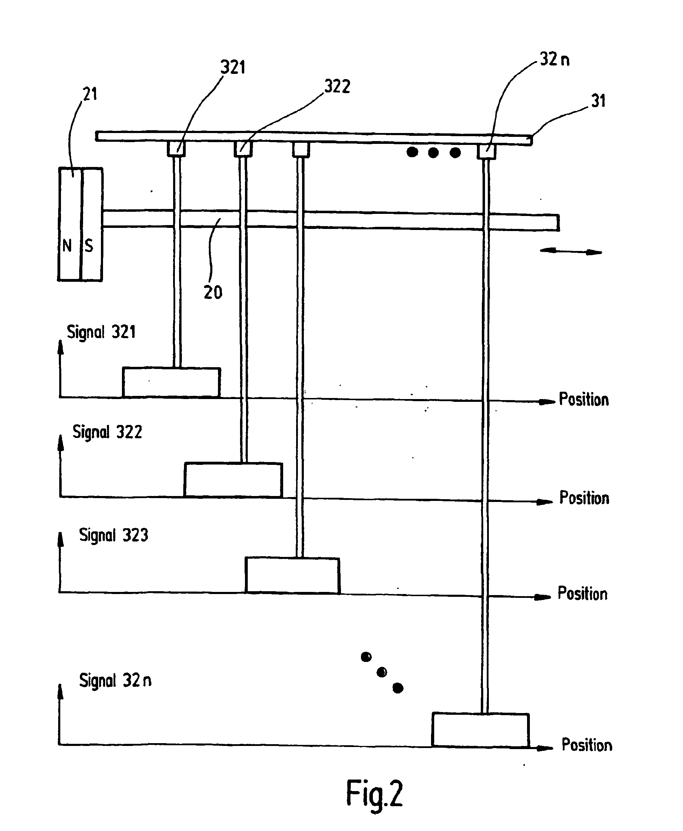

Fig. 2 zeigt die Übertragungsfunktion der Hallschalter 32 in Abhängigkeit von der Position des Kolbens und des mit ihm verbundenen Permanentmagneten 21. Immer wenn der Permanentmagnet 21 an einem Hallschalter 321, 322 ... 32n vorbeistreicht, wird ein im wesentlichen rechteckförmiger Signalimpuls ausgelöst. Hierbei wird die erzielbare Auflösung der Anordnung von der Anzahl n der Hallschalter 32 bestimmt.

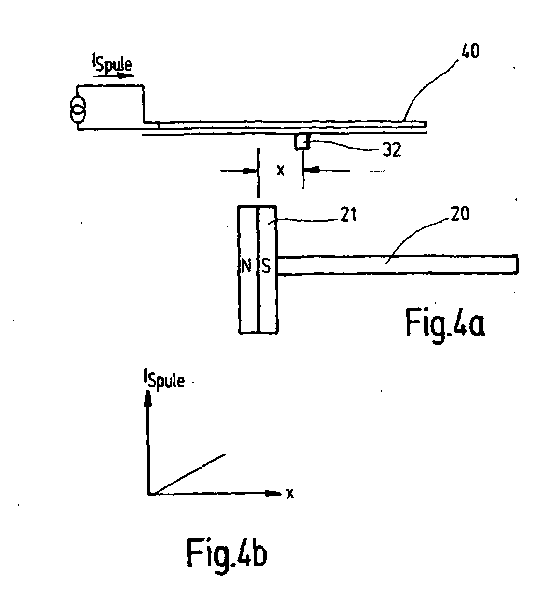

Um die Anzahl der Hallschalter 32 gering halten zu können, ist nun eine in Fig. 3 dargestellte beispielsweise im wesentlichen rechteckförmige Spule 40 vorgesehen, welche die Hallschalter 32 rahmenförmig umschließt. Diese Rahmenspule 40 kann beispielsweise aus Kupfer-Lackdraht gebildet sein, der auf einer Seite der Trägerplatte 31 angeordnet ist, wohingegen die Hallsensoren oder Hallschalter 32 auf der anderen Seite der Trägerplatte 31 angeordnet sind. Wird die Spule 40 von einem elektrischen Strom durchflossen, resultiert daraus ein Magnetfeld, das sich dem Magnetfeld des Permanentmagneten 21 des Kolbens 20 überlagert. Hierdurch ergibt sich die Möglichkeit über die Größe des Spulenstromes die magnetische Flußdichte am Einbauort der Hallschalter 32 zu variieren, wodurch wiederum gewissermaßen eine Interpolation des Ansprechverhaltens zwischen den einzelnen Hallschaltern 32 und damit eine Steigerung der Auflösung der Positionsbestimmung des Kolbens 20 ermöglicht wird.

In Fig. 4a ist schematisch die Anordnung des Kolbens 20 und der Rahmenspule 40, die mit einem Strom I_{Spule} beaufschlagt wird, dargestellt. Befindet sich beispielsweise der Permanentmagnet 21 des Kolbens 20 in einem Abstand x von einem Hallschalter 32, so ergibt sich ein im wesentlichen linearer Verlauf des Stroms, bei dem der Hallschalter 32 anspricht, über diesem Abstand x (in Fig. 4b schematisch dargestellt).

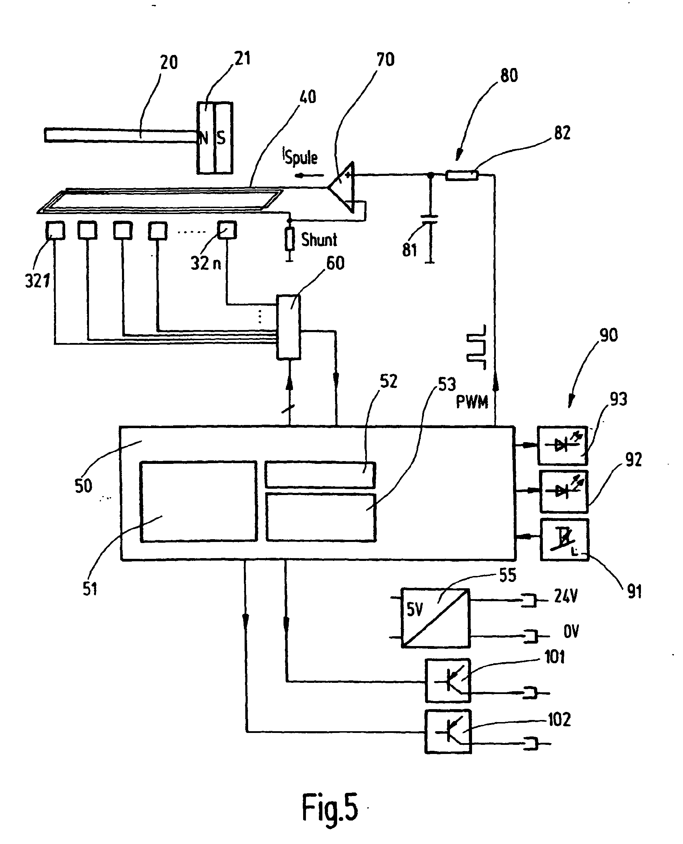

Ein Meßvorgang wird nun nachfolgend in Verbindung mit Fig. 5 beschrieben.

Nachdem der Kolben 20 und mit ihm der Permanentmagnet 21 in eine Position verschoben wurde, die später zu detektieren ist, wird der Spulenstrom I_{Spule} beginnend bei dem Wert Null schrittweise erhöht, bis ein Hallschalter 32 anspricht. Die Nummer des Hallschalters, in Fig. 5 mit 1 bis n bezeichnet, und der zugehörige Spulenstrom I_{Spule} repräsentieren dann eindeutig die Position des Zylinderkolbens 20.

Der gesamte Meßvorgang wird von einem Microcontroller 50 gesteuert. Der Microcontroller 50 weist neben einem Programmspeicher 51 auch einen Datenspeicher 52 sowie ein nichtflüchtiges Datenspeichermedium 53, beispielsweise ein EEPROM, auf.

Die Hallschalter 32 werden über einen von dem Microcontroller 50 gesteuerten Multiplexer 60 ausgewählt und deren Schaltzustände seriell eingelesen.

Zur Versorgung der Rahmenspule oder auch Interpolationsspule 40 ist ein Stromregler 70 vorgesehen, der jeweils den Spulenstom I_{Spule} unabhängig von der Versorgungsspannung und der Spulentemperatur konstant hält. Die Größe des Spulenstroms I_{Spule} wird über einen pulsweitenmodulierten Ausgang des Microcontrollers 50 vorgegeben. Dazu wird ein PWM-Signal (pulsweitenmoduliertes Signal) zunächst über einen Tiefpaßfilter 80, umfassend einen Kondesator 81 und einen Widerstand 82 integriert. Der Microcontroller 50 selbst wird von einem Versorgungsnetzteil 55 mit Versorgungsspannung versorgt.

Zur Bedienung der Anordnung ist ein Bedienerinterface 90, umfassend eine Bedienungstaste 91 und zwei Anzeigemittel, beispielsweise Leuchtdioden 92 und 93, vorgesehen. Zur Meldung oder Ausgabe einer Position des Kolbens 20 sind beispielsweise zwei Transistorschaltausgänge 101, 102 vorgesehen.

Das im Pogrammspeicher 51 des Microcontrollers 50 hinterlegte Programm weist zwei wesentliche Hauptblöcke auf. Der erste Hauptblock dient dem Einstellen der Schaltpunkte. Diese Einstellung wird wie folgt vorgenommen. Nachdem eine Bedienungsperson die Bedientaste 91 gedrückt hat, wechselt der Microcontroller 50 in einen Einstellmode. Die Kolbenstange 20 und mit ihr der an ihr befestigte Permanentmagnet 21 muß dann in die Position verschoben werden, für die der jeweilige Schaltausgang ein Signal ausgeben soll. Der Microcontroller 50 ermittelt sodann die Nummer n des aktiven Hallschalters 32 und die Größe des zugehörigen Spulenstroms I_{Spule}. Beide Werte werden in dem nichtflüchtigen Datenspeicher, dem EEPROM 53 des Microcontrollers 50 gespeichert.

Der zweite Hauptblock dient dem Meßbetrieb, der auf die nachfolgend beschriebene Weise erfolgt. Der Microcontroller 50 ermittelt ständig sowohl die Nummer n des aktiven Hallschalters 32 als auch den zugehörigen Spulenstrom I_{Spute} und vergleicht diese Werte mit den in dem EEPROM 53 gespeicherten Daten. Bei Übereinstimmung wird der dem Schaltpunkt zugehörige Ausgangstransistor 101 oder 102 durchgeschaltet.

Durch den kompakten Aufbau des Hallsensorarrays 30 ist es möglich, dieses komplett in eine Wand oder in das Profil des Zylinders 10 einzubauen. Eine Festlegung der Position ist möglich, ohne daß mechanische Einstellarbeiten, beispielsweise Verschieben von Hallschaltern oder dergleichen notwendig ist. Hierdurch kann der Zylinder 10 eine vollständig glatte Außenfläche aufweisen und ist so beispielsweise zum Einsatz in der Lebensmittel- und Pharmaindustrie geeignet. Durch die elektronische Inbetriebnahme und das Einstellen der Schaltpunkte, die keinerlei mechanische Einstellarbeiten erfordert, können darüber hinaus Inbetriebnahmezeiten deutlich vertcürzt werden.

Besonders vorteilhaft ist es, daß das vorbeschriebene Hallsensorarray 30 nur eine begrenzte kleine Anzahl von Hallsensoren 32 erfordert. Durch die Rahmenspule oder Interpolationsspule 40 kann über den Spulenstrom I_{Spule} nämlich der Schaltpunkt der Hallschalter 32 eingestellt werden und so theoretisch eine unendliche Auflösung realisiert werden. Es muß lediglich der Spulenstrom I_{Spule} solange erhöht werden, bis ein Hallschalter 32 anspricht.

## Patentansprüche

1. Positionsmeßvorrichtung für fluidische Zylinder-Kolben-Anordnungen mit wenigstens einem vorzugsweise im Zylinderwandbereich, insbesondere in einer Zylinderwand angeordneten Hallsensor (32) und mit einem mit diesem zusammenwirkenden, in dem Kolben (20) angeordneten magnetischen Bereich (21), **gekennzeichnet durch** ein Hallsensorarray (30) umfassend wenigstens zwei in Bewegungsrichtung des Kolbens voneinander beabstandete Hallsensoren (321, 322, ... 32n) und eine mit einem Strom beaufschlagbare Spule (40), **durch** deren Magnetfeld die Schaltpunkte der Hallsensoren (321, 322, ... 32n) abhängig von dem Spulenstrom (I_{Spule}) einstellbar sind.

2. Positionsmeßvorrichtung nach Anspruch 1, **dadurch gekennzeichnet, daß** das Hallsensorarray (30) eine Mehrzahl von gleich beabstandeten, vorzugsweise auf einer Trägerplatte (31) angeordneten Hallsensoren oder Hallschalter (321, 322, ... 32n) umfaßt.

3. Positionsmeßvorrichtung nach Anspruch 2, **dadurch gekennzeichnet, daß** die Hallsensoren oder Hallschalter (321, 322, ... 32n) hintereinanderliegend angeordnet sind und von einer im wesentlichen rechteckförmigen rahmenförmigen Spule (Rahmenspule 40) umgeben sind.

4. Positionsmeßvorrichtung nach Anspruch 3, **dadurch gekennzeichnet, daß** die Rahmenspule (40) auf einer Seite der Trägerplatte (31) angeordnet ist, wohingegen die Hallsensoren oder Hallschalter (321, 322, ... 32n) auf der anderen Seite der Trägerplatte (31) angeordnet sind.

5. Positionsmeßvorrichtung nach einem der Ansprüche 1 bis 4, **dadurch gekennzeichnet, daß** die Hallsensoren oder Hallschalter (321, 322, ... 32n) mittels eines Multiplexers (60) ausgewählt und ihre Schaltzustände einem Mikrocontroller (50) zugeführt werden.

6. Positionsmeßvorrichtung nach einem der Ansprüche 1 bis 5, **dadurch gekennzeichnet, daß** ein Stromregler (70) vorgesehen ist, mit dem der Spulenstrom (I_{Spule}) insbesondere unabhängig von der Versorgungsspannung und von der Spulentemperatur jeweils auf einen konstanten Wert einstellbar ist.

7. Positionsmeßvorrichtung nach einem der Ansprüche 1 bis 6, **dadurch gekennzeichnet, daß** der Stromregler (70) von dem Mikrocontroller (50) ansteuerbar ist.

8. Positionsrneßvorrichtung nach einem der Ansprüche 1 bis 7, **dadurch gekennzeichnet, daß** zur Festlegung einer zu detektierenden Position des Kolbens (20) eine Positionsnummer (n) eines Hallsensors oder Hallschalters (321, 322, ... 32n) und die Größe des Spulenstroms (I_{Spule}) in einem Speicher (53) des Mikrocontrollers (50) abgelegt werden.

9. Positionsmeßvorrichtung nach Anspruch 8, **dadurch gekennzeichnet, daß** der Mikrocontroller (50) im Betrieb der Zylinder-Kolben-Anordnung die Positionsnummer (n) eines aktiven Hallsensors oder Hallschalters (321, 322, ... 32n) und den zugehörigen Spulenstrom (I_{Spule}) ermittelt, mit in dem Speicher (53) des Mikrocontrollers (50) gespeicherten Werten vergleicht und im Falle der Übereinstimmung ein Ausgangssignal ausgibt.

## Claims

1. Position-measuring device for fluidic cylinder/piston arrangements having at least one Hall sensor (32), which is preferably arranged in the region of a cylinder wall, in particular in a cylinder wall, and having a magnetic region (21) which interacts with said Hall sensor (32) and is arranged in the piston (20), **characterized by** a Hall sensor array (30) comprising at least two Hall sensors (321, 322, ... 32n) spaced apart from one another in the movement direction of the piston and a coil (40), to which current can be applied and by means of whose magnetic field it is possible to adjust the switching points of the Hall sensors (321, 322, ... 32n) depending on the coil current (I_{coil}).

2. Position-measuring device according to Claim 1, **characterized in that** the Hall sensor array (30) comprises a plurality of Hall sensors or Hall-effect switches (321, 322, ... 32n) which are spaced evenly apart and are preferably arranged on a mounting plate (31) .

3. Position-measuring device according to Claim 2, **characterized in that** the Hall sensors or Hall-effect switches (321, 322, ... 32n) are arranged one behind the other and are surrounded by an essentially rectangular, frame-shaped coil (frame coil 40).

4. Position-measuring device according to Claim 3, **characterized in that** the frame coil (40) is arranged on one side of the mounting plate (31), whereas the Hall sensors or Hall-effect switches (321, 322, ... 32n) are arranged on the other side of the mounting plate (31).

5. Position-measuring device according to one of Claims 1 to 4, **characterized in that** the Hall sensors or Hall-effect switches (321, 322, ... 32n) are selected by means of a multiplexer (60) and their switching states are fed to a microcontroller (50).

6. Position-measuring device according to one of Claims 1 to 5, **characterized in that** a current regulator (70) is provided which can be used to adjust the coil current (I_{coil}) in each case to a constant value, in particular independently of the supply voltage and of the coil temperature.

7. Position-measuring device according to one of Claims 1 to 6, **characterized in that** the current regulator (70) can be driven by the microcontroller (50).

8. Position-measuring device according to one of Claims 1 to 7, **characterized in that**, in order to fix a position to be detected for the piston (20), a position number (n) of a Hall sensor or Hall-effect switch (321, 322, ... 32n) and the variable for the coil current (Icon) are stored in a memory (53) of the microcontroller (50).

9. Position-measuring device according to Claim 8, **characterized in that** the microcontroller (50) determines the position number (n) of an active Hall sensor or Hall-effect switch (321, 322, ... 32n) and the associated coil current (I_{coil}) during operation of the cylinder/piston arrangement, compares it with values stored in the memory (53) of the microcontroller (50) and emits an output signal in the event that the values correspond.

## Revendications

1. Dispositif de mesure de position pour des systèmes de vérins fluidiques, comprenant au moins un capteur Hall (32) de préférence dans la zone de paroi du vérin, en particulier dans une paroi de cylindre, avec disposée dans le piston (20) une zone magnétique (21) coopérant avec le capteur,
**caractérisé par**
un ensemble de capteurs à effet Hall (30) comprenant au moins deux capteurs à effet Hall (321, 322,... 32n) écartés l'un de l'autre dans la direction de mouvement du piston et une bobine (40) pouvant être sollicitée par un courant, et dont le champ magnétique permet de régler les points de commutation des capteurs à effet Hall (321, 322,... 32n) en fonction du courant de la bobine (I_{Spule}).

2. Dispositif de mesure de position selon la revendication 1,
**caractérisé en ce que**
l'ensemble de capteurs à effet Hall (30) comprend une pluralité de capteurs à effet Hall ou commutateurs à effet Hall (321, 322, .. 32n) équidistants les uns des autres, de préférence sur une plaque de support (31).

3. Dispositif de mesure de position selon la revendication 2,
**caractérisé en ce que**
les capteurs à effet Hall ou les commutateurs à effet Hall (321, 322, ... 32n) sont placés les uns derrière les autres et entourés par une bobine en forme de cadre pour l'essentiel rectangulaire (bobine cadre 40).

4. Dispositif de mesure de position selon la revendication 3,
**caractérisé en ce que**
la bobine cadre (40) est disposée sur un côté de la plaque de support (31), tandis que les capteurs à effet Hall ou les commutateurs à effet Hall (321, 322, ... 32n) sont disposés sur l'autre côté de la plaque de support (31).

5. Dispositif de mesure de position selon l'une des revendications 1 à 4,
**caractérisé en ce que**
les capteurs à effet Hall ou les commutateurs à effet Hall (321, 322, ... 32n) sont sélectionnés au moyen d'un multiplexeur (60) et leurs états de commutation sont transmis à un microcontrôleur (50).

6. Dispositif de mesure de position selon l'une des revendications 1 à 4,
**caractérisé en ce qu'**
un régulateur de courant (70) permet de régler à une valeur constante le courant de la bobine (I_{Spule}) en particulier indépendamment de la tension d'alimentation et de la température de bobine.

7. Dispositif de mesure de position selon l'une des revendications 1 à 6,
**caractérisé en ce que**
le régulateur de courant (70) peut être commandé par le microcontrôleur (50).

8. Dispositif de mesure de position selon l'une des revendications 1 à 7,
**caractérisé en ce que**
pour déterminer une position du piston (20) à détecter, un numéro de position (n) d'un capteur à effet Hall ou d'un commutateur à effet Hall (321, 322, ... 32n) ainsi que la valeur du courant de la bobine (I_{Spule}) sont enregistrés dans une mémoire (53) du microcontrôleur (50).

9. Dispositif de mesure de position selon la revendication 8,
**caractérisé en ce que**
lorsque le système cylindre-piston est en fonctionnement, le microcontrôleur (50) détermine le numéro de position (n) d'un capteur à effet Hall actif ou d'un commutateur à effet Hall actif (321, 322, ... 32n) ainsi que le courant de la bobine associé (I_{Spule}), les compare aux valeurs enregistrées dans la mémoire (53) du microcontrôleur (50) et dans le cas d'une concordance, émet un signal de sortie.
